(19) Europäisches Patentamt
European Patent Office
Office européen des brevets

(11) **EP 3 082 078 A1**

(12) **EUROPEAN PATENT APPLICATION**

(43) Date of publication:
**19.10.2016 Bulletin 2016/42**

(51) Int Cl.:
**G06Q 10/04** *(2012.01)* **G06Q 50/06** *(2012.01)*
**G01R 22/06** *(2006.01)*

(21) Application number: **15185859.4**

(22) Date of filing: **18.09.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **16.04.2015 US 201514688945**

(71) Applicant: **FUJITSU LIMITED**
**Kawasaki-shi,**
**Kanagawa 211-8588 (JP)**

(72) Inventor: **Mashima, Daisuke**
**Sunnyvale, CA 94085 (US)**

(74) Representative: **Hoffmann Eitle**
**Patent- und Rechtsanwälte PartmbB**
**Arabellastraße 30**
**81925 München (DE)**

(54) **AUTHENTICATED DOWN-SAMPLING OF TIME-SERIES DATA**

(57) A method of down-sampling time-series data may include receiving energy usage data representative of energy usage of a customer during a specified period. The energy usage data may be signed with a digital signature of a utility. The method may also include receiving input from a customer effective to select a granularity level to apply to the energy usage data and the energy usage data may be down-sampled to apply the selected granularity level to the energy usage data and produce down-sampled energy usage data. The method may also include communicating the down-sampled energy usage data and hash values of child nodes corresponding to the down-sampled energy usage data to a third party.

Fig. 1A

## Description

FIELD

The embodiments discussed herein are related to authenticated down-sampling of time-series data.

BACKGROUND

Broad penetration of smart meters and advanced metering infrastructure (AMI) has enabled bidirectional communication between utilities and customers and collection of fine-grained energy consumption data. The broad penetration of the smart meters may provide some benefits to both the generation and distribution side and the demand side of energy systems. For instance, a utility may use collected data to better predict peak demand, which may help to avoid service outages, reduce generation cost, and improve the stability of the grid. Also, customers may benefit by knowing and optimizing their energy consumption patterns to improve energy efficiency.

The landscape around data management and sharing in smart grid systems is getting more complicated. For instance, data analytics on energy usage data representative of energy usage of customers is often outsourced by utilities to third parties. An example is the partnership between PG&E, a utility company, and Opower, a software-as-a-service company, which provides PG&E recommendation services. Another example of third party services includes demand-response (DR) aggregators that facilitate large-scale DR services.

Such third party services may play an important role in the smart grid, but privacy of the customers may not be the first priority. For instance some DR aggregators install their own metering device at sites to obtain meter reading data and facilitate provision of their services. Thus, the energy usage data combined with personally identifiable information may be collected by the DR aggregators as well as by the utility. The DR aggregators may gather as much information as it wants, regardless of whether such information is needed for providing services. A similar concern may be raised if services are outsourced to a third party and customers do not have direct control over data sharing.

Smart meters may measure and report electricity consumption as a time-series of data which represents the energy usage of a customer. This time-series data may be useful for a number of legitimate services. For example, the utility company supplying electricity to the customer may need energy usage data at the highest possible resolution (i.e., the shortest possible sampling rate) for stable grid operation and to accurately forecast peak electricity demand. On the other hand, the customer's energy usage data may also be exploited by third parties to violate the customer's privacy. For example, non-intrusive load monitoring (NILM) may reveal sensitive information about the customer, including the customer's lifestyle, habits, personal schedule, the number and types of appliances the customer has in his home, etc. Thus, it may be desirable to share lower resolution energy usage data with third parties to protect the customer's privacy by reducing the granularity of the customer's energy usage data.

Demand response providers (DRPs) may provide monetary incentives to the customer in order to incentivize the customer to lower his energy usage during a demand response event. In the aggregate, these incentive programs may decrease electricity consumption during peak demand periods and/or shift electricity usage from "on-peak" to "off-peak" time periods. However, demand response providers often require assessment of a customer's actual energy usage during the demand response event in order to verify the integrity and authenticity of the customer's energy usage data before the DRP disburses the monetary incentive to the customer.

The subject matter claimed herein is not limited to embodiments that solve any disadvantages or that operate only in environments such as those described above. Rather, this background is only provided to illustrate one example technology area where some embodiments described herein may be practiced.

SUMMARY

According to an aspect of an embodiment, a method may include receiving energy usage data representative of energy usage of a customer during a specified period. The energy usage data may be signed with a digital signature of a utility. The method may also include receiving input from a customer effective to select a granularity level to apply to the energy usage data and the energy usage data may be down-sampled to apply the selected granularity level to the energy usage data and produce down-sampled energy usage data. In some embodiments, the down-sampled energy usage data may be produced without invalidating the utility's digital signature. The method may also include communicating the down-sampled energy usage data and hash values of child nodes corresponding to the down-sampled energy usage data to a third party.

The object and advantages of the embodiments will be realized and achieved at least by the elements, features, and combinations particularly pointed out in the claims.

It is to be understood that both the foregoing general description and the following detailed description are exemplary and explanatory and are not restrictive of the invention, as claimed.

BRIEF DESCRIPTION OF THE DRAWINGS

Example embodiments will be described and explained with additional specificity and detail through the use of the accompanying drawings in which:

FIGS. 1A and 1B illustrate block diagrams of an example system in which energy usage data may be communicated;

FIG. 2 illustrates an example modified Merkle hash tree that may be implemented in the system of FIGS. 1A and 1B;

FIG. 3 is a flow diagram of an example method of generating digitally-signed time-series data;

FIG. 4A is a flow diagram of an example method of down-sampling time-series data;

FIG. 4B is a flow diagram of another example method of down-sampling time-series data;

FIG. 5 is a flow diagram of an example method of verifying down-sampled time-series data; and

FIG. 6 is a block diagram illustrating an example computing device that is arranged for down-sampling and/or redaction of time-series data.

DESCRIPTION OF EMBODIMENTS

Methods disclosed herein allow a customer to protect the customer's privacy while sharing energy usage data with third parties by allowing the customer to flexibly control the amount of information that may be derived from the energy usage data. The customer may decide to share a certain amount of information with the third party based on the third party's trustworthiness or the nature of the services provided by the third party.

Accordingly, some embodiments discussed herein include a customer-centric framework to manage, store, and share the energy usage data in a privacy-enhanced way. Some embodiments include a mechanism to enable customers to flexibly control the amount of energy usage information disclosed while allowing third party service providers to be convinced of the authenticity of data. In at least one embodiment, the customer may accomplish this by downloading digitally signed time-series energy usage data of the customer from a data issuer (such as a utility company), then down-sampling the energy usage data, without invalidating the data issuer's digital signature, by aggregating energy measurement data points together before sharing the down-sampled energy usage data with the third party. This allows the customer to reduce the granularity of his energy usage data and better protect his privacy. Lower frequency energy usage data measurements have lower privacy risk compared to higher frequency energy usage data measurements. For example, if energy usage data is measured once every 15 minutes, then the customer may reduce the granularity by down-sampling the energy usage date to show energy usage for 30 minute time intervals (or 1 hour or 2 hour time intervals) by aggregating the appropriate data usage measurements together.

In these and other embodiments, down-sampling may be enabled by implementation of a binary-tree based scheme (e.g., a modified Merkle hash tree) such that down-sampled time intervals may be integer power of 2 (e.g., 2, 4, 8, 16, ...) multiples of a time interval associated with highest frequency time-series data measurements. For instance, if the highest frequency time-series data measurements are associated with 15 minute time intervals, down-sampled time intervals may be 30 minutes (e.g., 2 X 15 minutes = 30 minutes), 1 hour (e.g., 4 X 15 minutes = 60 minutes), 2 hours (e.g., 8 X 15 minutes = 120 minutes), and so on. In other embodiments, down-sampling may be enabled by implementation of an N-ary-tree based scheme such that down-sampled time intervals may be integer power of N (e.g., $N^1$, $N^2$, $N^3$, $N^4$, ...) multiples of the time interval associated with the highest frequency time-series data measurements.

The down-sampling processes disclosed herein may be designed so as to not interfere with the original digital signature of the data issuer. In this manner, the third party may still use the data issuer's digital signature to verify that the customer's down-sampled energy usage data is authentic and was generated from real energy usage data that was not tampered with, just down-sampled. At the same time, the customer may protect the customer's privacy by providing down-sampled energy usage data to the third party. These and other embodiments are described with reference to the appended drawings.

In the following description, details are set forth by way of example to facilitate discussion of the disclosed subject matter. The disclosed embodiments are provided by way of example only and are not exhaustive of all possible embodiments. Some embodiments will be explained with reference to the accompanying drawings.

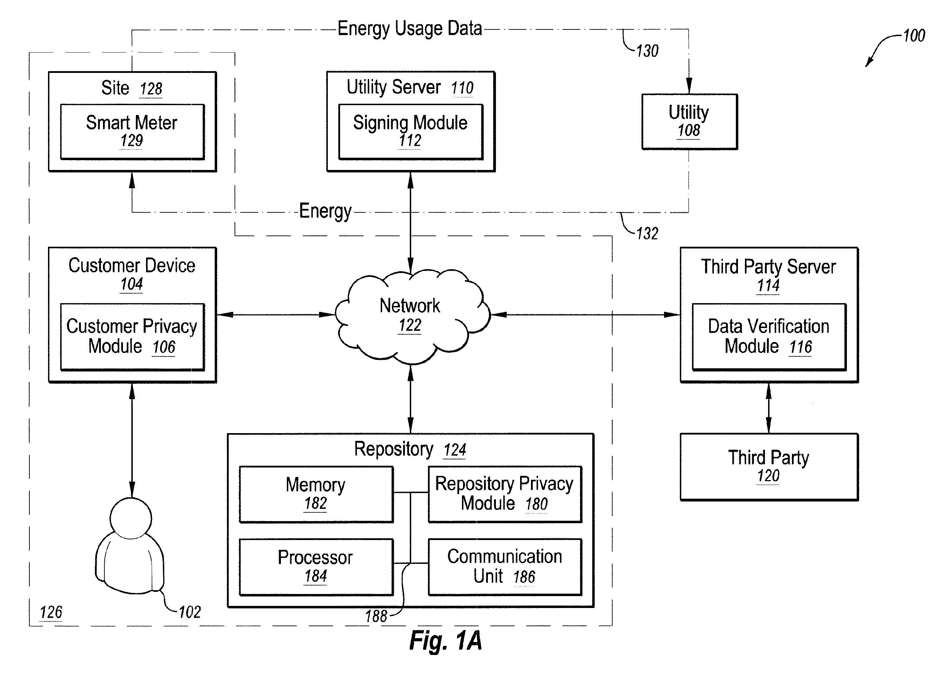

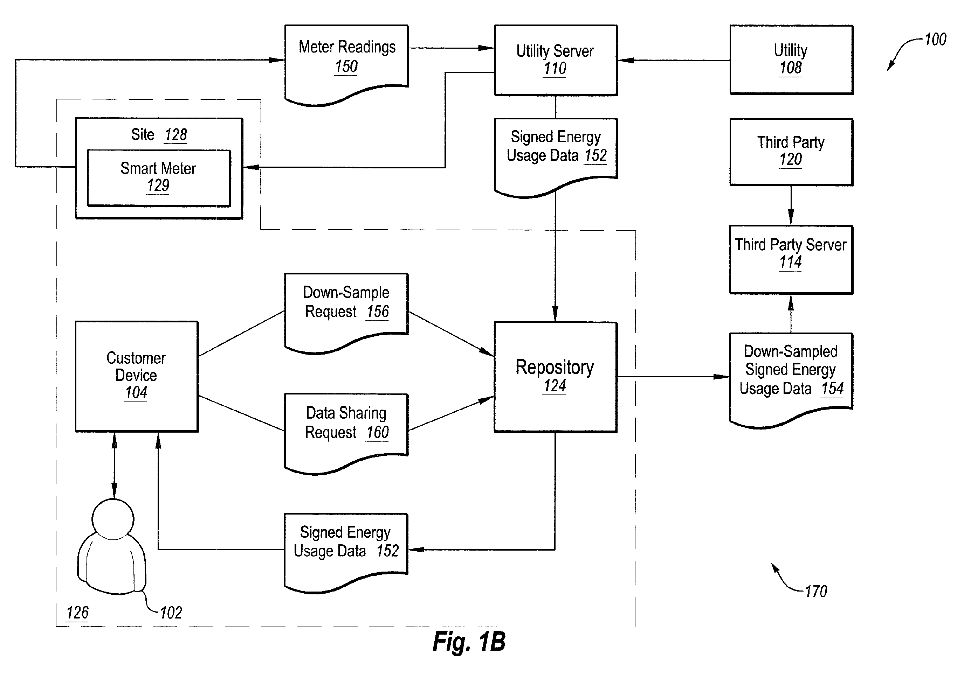

FIGS. 1A and 1B illustrate block diagrams of an example system 100 in which energy usage data may be communicated, arranged in accordance with at least one embodiment described herein. For example, the energy usage data may be communicated to a third party 120 such that a service may be performed based on the energy usage data. In the system 100, energy usage data may be generated that indicates energy usage at a site 128. For example, the energy usage data may be representative of electrical energy usage at the site 128. The site 128 may be associated with a customer 102 and energy usage of the site 128 may result from behaviors or actions of the customer 102, including operation of one or more energy-consuming devices at the site 128. Accordingly, the energy usage data may present privacy concerns to the customer 102 because behaviors and actions of the customer 102 may be derived from the energy usage data. For example, a particular appliance the customer 102 uses at a particular time may be derived from the energy usage data.

The system 100 may be configured as a customer-centric system in which the customer 102 has control over the energy usage data generated at the site 128. For example, the system 100 may include a customer domain 126. The customer domain 126 may include a customer device 104, a repository 124 or some portion thereof, and some portion of a network 122. When the energy usage data is in the customer domain 126, the customer 102 may at least partially control the energy usage data. For example, the customer 102 may control which portions of the energy usage data are viewable or private and/or which entities (e.g., a third party 120) have access to the energy usage data.

In the system 100, the customer 102 may have an incentive to provide the energy usage data, or some portion thereof, to the third party 120. For example, the third party 120 may include a service provider that assesses the energy usage data to determine whether the customer 102 receives an incentive for energy efficiency or demand response contribution. Prior to communication of the energy usage data, the customer 102 may down-sample the energy usage data and/or redact portions thereof to limit granularity and availability of the energy usage data that may introduce privacy issues. In some embodiments, redaction may be performed at least partially as disclosed in U.S. Patent Application No.: 14/498,942, entitled "ENERGY USAGE DATA MANAGEMENT" filed September 26, 2014, which is incorporated herein by reference in its entirety.

However, the third party 120 may want assurances as to the validity and/or source of the modified data (for instance, to disburse monetary incentive according to the amount of demand response contribution in a fair way). In the system 100, a utility 108 may provide energy to the site 128 and collect energy usage data using a smart meter 129. Thus, the third party 120 may want assurances that a source of the energy usage data is the utility 108 and that the energy usage data has not been tampered with prior to being communicated to the third party 120.

In the system 100, a data structure may be employed that allows the customer 102 to down-sample the time-series energy usage data while enabling the third party 120 to verify a source of the energy usage data and to authenticate accuracy of the energy usage data. In some embodiments discussed herein, the data structure employed may include a modified Merkle hash tree. The modified Merkle hash tree may generally enable down-sampling and generation of redactable signatures that allow verification and authentication of the energy usage data. In some embodiments, use of the modified Merkle hash tree may be performed at least partially as disclosed in U.S. Patent Application No.: 13/942,995, entitled "Customer-Centric Energy Usage Data Sharing" filed July 16, 2013, which is incorporated herein by reference in its entirety.

The system 100 depicted in Fig. 1A may include the utility 108, the third party 120, the site 128, the repository 124, and the customer 102. The utility 108 may be associated with the utility server 110 and the smart meter 129, the customer 102 may be associated with the site 128, and the customer device 104, and the third party 120 may be associated with a third party server 114. The term "associated with" may indicate ownership and/or direct or indirect control of the corresponding one of the utility server 110, the smart meter 129, the site 128, the customer device 104, or the third party server 114. For example, the third party server 114 may be owned and/or controlled by the third party 120. In addition, the utility server 110 and the smart meter 129 may be owned and/or controlled by the utility 108. In addition, the site 128 and the customer device 104 may be owned and/or controlled by the customer 102. Accordingly, communications with and actions attributed to the customer 102 may occur at the customer device 104. Similarly, communications with and actions attributed to the third party 120 may occur at the third party server 114. Similarly, communications with and actions attributed to the utility 108 may occur at the utility server 110.

In the system 100, data sets including energy usage data or portions thereof as well as other messages and information may be communicated between the utility server 110, the third party server 114, the repository 124, the smart meter 129, and the customer device 104 via the network 122. The network 122 may be wired or wireless, and may have numerous configurations including a star configuration, token ring configuration, or other configurations. The network 122 may include a local area network (LAN), a wide area network (WAN) (e.g., the Internet), and/or other interconnected data paths across which multiple devices may communicate. In some embodiments, the network 122 may include a peer-to-peer network. The network 122 may also be coupled to or include portions of a telecommunications network that may enable communication of data in a variety of different communication protocols. In some embodiments, the network 122 may include BLUETOOTH® communication networks and/or cellular communication networks for sending and receiving data via short messaging service (SMS), multimedia messaging service (MMS), hypertext transfer protocol (HTTP), direct data connection, wireless application protocol (WAP), e-mail, etc.

In the system 100, the utility 108 may distribute energy (e.g., electricity) to the site 128. The distribution of the energy by the utility 108 to the site 128 is denoted in FIG. 1A at 132. Additionally, the utility 108 may collect energy usage data from the site 128 using the smart meter 129. The collection of energy usage data is denoted in FIG. 1A at 130. The utility 108 may include any entity involved in production, transmission, and/or distribution of electricity. The utility 108 may be publicly owned or may be privately owned. Some examples of the utility 108 may include a power plant, an energy cooperative, and an independent system operator (ISO).

In some embodiments, the third party 120 may include a DR aggregator and the energy usage data may be communicated between the customer 102, the repository 124, and the third party server 114 at least partially for assessment of energy usage in a context of a DR event or other context. In these and other embodiments, the utility 108 may set terms for DR events. For example, the utility 108 may set an incentive exchange for participation in the DR event, a time period of the DR event, duration of the DR event, and an energy usage curtailment for the DR event. The terms of the DR events may be communicated to the customer 102 via the customer device 104 and/or the third party 120 via the third party server 114.

Additionally, one or more of the embodiments discussed herein may be utilized in other systems in which data other than energy usage data may be communicated between customers 102 or other data subjects and third parties. In these embodiments, the energy usage data may more generally include time-series data and the utility 108 may more generally be an entity that signs or otherwise initially authenticates the time-series data prior to down-sampling by the customer 102 or another data subject.

The site 128 may include buildings, structures, equipment, or other objects that use electricity distributed by the utility 108. The site 128 may have adapted thereto a meter such as the smart meter 129 that measures the energy distributed to the site 128. The smart meter 129 may communicate the energy usage data to the utility 108. In some embodiments, the energy usage data may be communicated to the utility 108 via the network 122. Based on the energy usage data, the utility 108 may ascertain the energy usage of the site 128, which may be used to bill the customer 102, for example. In embodiments in which data other than energy usage data is communicated, the site 128 may be omitted.

The utility server 110 associated with the utility 108 may include a hardware server that includes a processor, a memory, and network communication capabilities. In the illustrated embodiment, the utility server 110 may be coupled to the network 122 to send and receive data to and/or from the smart meter 129, the customer device 104, the repository 124, and the third party server 114 via the network 122.

The utility server 110 may include a signing module 112. The signing module 112 may include code and routines for privacy-preserving communication described herein. In some embodiments, the signing module 112 may be implemented using hardware including a field-programmable gate array (FPGA) or an application-specific integrated circuit (ASIC). In some other instances, the signing module 112 may be implemented using a combination of hardware and software.

The signing module 112 may be configured to receive the energy usage data from the smart meter 129 or another suitable data measuring system at the site 128. The energy usage data received at the signing module 112 may include data representative of energy usage as a function of time, which is one example of time-series data to which some embodiments described herein may be applied. The signing module 112 may use a data structure such as the modified Merkle hash tree to enable the customer 102 to down-sample and/or redact portions of the energy usage data while enabling the third party 120 to verify a source of the energy usage data and authenticate the energy usage data received from the customer 102.

In embodiments implementing the modified Merkle hash tree, the signing module 112 may calculate a root hash of the modified Merkle hash tree, which may be signed using a private key of the utility 108. The root hash may be calculated based on a sum of all data values pertaining to a root node of the Merkle hash tree and based on a concatenation of hash values of child nodes of the root node, as described in more detail below.

The customer 102 may include individuals, groups of individuals, or other entities, for example. The site 128 and the customer device 104 may be associated with the customer 102. In some embodiments, the customer 102 may determine how much to down-sample the energy usage data.

The customer device 104 associated with the customer 102 may include a computing device that includes a processor, memory, and network communication capabilities. For example, the customer device 104 may include a laptop computer, a desktop computer, a tablet computer, a mobile telephone, a personal digital assistant ("PDA"), a smartphone, a mobile e-mail device, a portable game player, a portable music player, a television with one or more processors embedded therein or coupled thereto, or other electronic device capable of accessing the network 122.

The customer device 104 may include a customer privacy module 106. The customer privacy module 106 may include code and routines for privacy-preserving communication. In some embodiments, the customer privacy module 106 may act in part as a thin-client application that may be stored on a computing device (e.g., the customer device 104) and in part as components that may be stored on other computing devices such as the repository 124, and the utility server 110, for instance. In some embodiments, the customer privacy module 106 may be implemented using hardware including an FPGA or an ASIC. In some other instances, the customer privacy module 106 may be implemented using a combination of hardware and software.

The repository 124 may receive energy usage data from the utility server 110, which energy usage data may be signed. The repository 124 may receive the energy usage data from the utility server 110 via a Green Button service, e.g., Green Button Connect My Data.. Alternatively or additionally, the customer device 104 may receive energy usage data (which may be signed) from the utility server 110, and the repository 124 may receive the energy usage data from the customer device 104. The customer device 104 may receive the energy usage data from the utility server 110 via a Green Button service as well, e.g., Green Button Download My Data.

The repository 124 may be included in the customer device 104 or may be separate from the customer device 104. The customer privacy module 106 may be configured to download or otherwise access the energy usage data from the repository 124. The customer privacy module 106 may enable the customer 102 to view the energy usage data. Additionally, the customer privacy module 106 may enable selection by the customer 102 of down-sampling levels and/or portions of the energy usage data for redaction.

The customer privacy module 106 may additionally or alternatively be included in a repository privacy module 180 or otherwise hosted by the repository 124. In these and other embodiments, the customer device 104 may act as a front end device, which may be used to access the customer privacy module 106 and/or information communicated to the customer privacy module 106. For example, the customer privacy module 106 may be run in a browser, which may provide an interface through which the customer 102 may interface with the customer privacy module 106.

The third party 120 may include a service provider or any other entity that has an interest in receiving the energy usage data. The third party 120 may include any service provider. For example, the third party 120 may be commissioned or otherwise hired to evaluate the energy usage data by the customer 102 and/or the utility 108; a commercial entity interested in energy markets, prevalence/usage of energy system equipment, advertising; a governmental regulator; a private regulator; and the like.

In some embodiments, the third party 120 may not be fully trusted by the customer 102 and/or the utility 108. In these and other embodiments, to minimize privacy concerns, energy usage data disclosure in the system 100 to the third party 120 may be minimized. For example, the energy usage data may be modified such that only data involved in performance of a service may be communicated to the third party 120.

The third party 120 may be associated with the third party server 114. The third party server 114 may include a hardware server that includes a processor, memory, and communication capabilities. In the illustrated embodiment, the third party server 114 may be coupled to the network 122 to send and receive information to and from the customer device 104 and/or the utility server 110 via the network 122.

In the depicted embodiment, the third party server 114 may include a data verification module 116. The data verification module 116 may include code and routines for privacy-preserving communication described herein. In some embodiments, the data verification module 116 may be implemented using hardware including an FPGA or an ASIC. In some other instances, the data verification module 116 may be implemented using a combination of hardware and software.

The data verification module 116 may be configured to request certain energy usage data from the customer device 104, the customer 102, or the repository 124. For instance, the data verification module 116 may be configured to request the certain energy usage data from the repository privacy module 180. In these embodiments, the customer 102 may then receive the request by interfacing with the repository privacy module 180 via the customer device 104.

The certain energy usage data requested by the third party 120 may include data from a particular time period. For example, the particular time period may include a time period corresponding to a DR event, a time period before and/or after a DR event, a historical time period for a baseline calculation, a time period since an occurrence (e.g., since installation of a heater or air-conditioning unit), a time period corresponding to a specific occurrence (e.g., energy usage data for days during a particularly warm period), a recurring time period during a specified period (e.g., 1:00 PM to 3:00 PM every day from June and July of 2013), or any other certain energy usage data.

The certain energy usage data from the DR event may be used as a basis for an evaluation. For example, in embodiments in which the third party 120 includes a DR aggregator, the energy usage data may be used to determine whether the customer 102 is in compliance with the DR event.

The data verification module 116 may be configured to receive the energy usage data that may be down-sampled. After the energy usage data is received, the data verification module 116 may reconstruct a data structure used to enable down-sampling of the energy usage data. Based on the reconstructed data structure, the data verification module 116 may verify a source of the energy usage data and/or authenticate the energy usage data.

In some embodiments, the data structure used to enable down-sampling of the energy usage data includes a modified Merkle hash tree. By reconstructing the modified Merkle hash tree, hash values of nodes of the modified Merkle hash tree may be calculated and the signature of the utility 108 may be verified. Thus, the energy usage data may be authenticated and verified based on the down-sampled energy usage data. In these and other embodiments, the data verification module 116 may be configured to calculate a root hash value and verify a root hash value against a signature of the utility 108. In some embodiments, the third party verification module 116 may access a public key of the utility 108 to verify the signature of the utility 108 on the root node.

The repository 124 may include any storage device or storage server that may be capable of communication via the network 122. The repository 124 may allow the energy usage data to be stored at least temporarily therein. The energy usage data may then be accessed. For example, the utility 108 may communicate the energy usage data collected from the site 128 using the smart meter 129 to the repository 124. The customer device 104 may then download or otherwise access the energy usage data or a portion thereof from the repository 124. The customer 102 may browse and/or process the downloaded energy usage data on the repository 124. Additionally or alternatively, the energy usage data may be downloaded by the customer 102 and then uploaded to the repository 124 by the customer 102.

In some embodiments, the repository 124 may include the repository privacy module 180, a memory 182, a processor 184, and a communication unit 186. The repository privacy module 180, the memory 182, the processor 184, and the communication unit 186 may be coupled via a bus 188.

The processor 184 may include an arithmetic logic unit (ALU), a microprocessor, a general-purpose controller, or some other processor or processor array to perform computations. The processor 184 may be coupled to the bus 188 for communication with the other components of the repository 124. The processor 184 generally processes data signals and may include various computing architectures including a complex instruction set computer (CISC) architecture, a reduced instruction set computer (RISC) architecture, or an architecture implementing a combination of instruction set architectures. Although FIG. 1A includes a single processor 184, multiple processors may be included in the repository 124 in which the multiple processors may be configured to perform individually or collectively one or more of the operations described herein, or to control performance of operations described herein.

The memory 182 may be configured to store instructions and/or data that may be executed by the processor 184. The memory 182 may be coupled to the bus 188 for communication with the other components. The instructions and/or data may include programming code executable by a processor for performing or controlling performance of the techniques or methods described herein. The memory 182 may include a dynamic random access memory (DRAM) device, a static random access memory (SRAM) device, flash memory, or some other memory device. In some embodiments, the memory 182 may also include a non-volatile memory or similar permanent storage device and media including a hard disk drive, a floppy disk drive, a CD-ROM device, a DVD-ROM device, a DVD-RAM device, a DVD-RW device, a flash memory device, or some other mass storage device for storing information on a more permanent basis.

The communication unit 186 may be configured to transmit and receive data to and from the customer device 104, the utility server 110, and/or the third party server 114. The communication unit 186 may be coupled to the bus 188. In some embodiments, the communication unit 186 may include a port for direct physical connection to the network 122 or to another communication channel. For example, the communication unit 186 may include a universal serial bus (USB), a standard definition (SD) port, category (CAT)-5 port, or similar port for wired communication with the components of the system 100. In some embodiments, the communication unit 186 includes a wireless transceiver for exchanging data via communication channels using one or more wireless communication methods, including IEEE 802.11, IEEE 802.16, BLUETOOTH®, global system for mobile (GSM), general packet radio service (GPRS), enhanced data rates for GSM evolution (EDGE), code division multiple access (CDMA), universal mobile telecommunications system (UMTS), long-term evolution (LTE), LTE-advanced (LTE-A), or another suitable wireless communication method.

In some embodiments, the communication unit 186 includes a cellular communications transceiver for sending and receiving data over a cellular communications network including via SMS, MMS, HTTP, direct data connection, WAP, e-mail, or another suitable type of electronic communication. In some embodiments, the communication unit 186 includes a wired port and a wireless transceiver. The communication unit 186 may also provide other conventional connections to the network 122 for distribution of files and/or media objects using standard network protocols including transmission control protocol/internet protocol (TCP/IP), HTTP, HTTP-secure (HTTPS), and simple mail transfer protocol (SMTP), etc.

The repository privacy module 180 may include code and routines for privacy-preserving communication. In some embodiments, the repository privacy module 180 may act in part as a thin-client application that may be stored on a computing device (e.g., the repository 124) and in part as components that may be stored on other computing devices such as the customer device 104 and the utility server 110, for instance. In some embodiments, the repository privacy module 180 may be implemented using hardware including an FPGA or an ASIC. In some other instances, the repository privacy module 180 may be implemented using a combination of hardware and software.

The repository privacy module 180 may be configured to receive or access the energy usage data via the network 122. The repository privacy module 180 may be further configured to receive input of the customer 102 via the customer device 104 effective to select down-sampling levels of the energy usage data. In some embodiments, the input of the customer 102 may include a down-sample request indicating what data to down-sample. Additionally or alternatively, the down-sample request of the customer 102 may indicate two or more different down-sampling levels to respectively apply to two or more different portions of the data. Additionally or alternatively, the input of the customer 102 may include a redaction request indicating what data to redact. Additionally or alternatively, the input of the customer 102 may include a policy selection, which may set a privacy level forming a basis of down-sampling levels or data selected by the repository privacy module 180 for redaction.

In response to the input of the customer 102, the repository privacy module 180 may down-sample the energy usage data. In some embodiments, the repository privacy module 180 may alternatively or additionally parse the energy usage data and redact data from the energy usage data according to the customer input. The repository privacy module 180 may then reconstruct the energy usage data such that the energy usage data is verifiable and authenticable by the third party 120. For example, down-sampling the data may include obscuring the data such that the data may not be ascertained with the same granularity as the original energy usage data. The repository privacy module 180 may then calculate or select appropriate hashes to send with the down-sampled data to enable the third party 120 to verify and authenticate the energy usage data by calculating the root hash value and comparing this value to the signed root hash value of the utility 108.

In some embodiments, the repository privacy module 180 may perform one or more functions described above with respect to the data verification module 116. For example, the repository privacy module 180 may be configured to receive energy usage data. After the energy usage data is received, the repository privacy module 180 may reconstruct a data structure used to enable down-sampling and generation of redactable signatures on the energy usage data. Based on the reconstructed data structure, the repository privacy module 180 may verify a source of the energy usage data.

In some embodiments, the modified Merkle hash tree may be used to enable down-sampling and generation of redactable signatures on the energy usage data. By reconstructing the modified Merkle hash tree, hash values of nodes of the modified Merkle hash tree may be calculated and the signature of the utility 108 may be verified. Thus, the energy usage data may be verified. In these and other embodiments, the repository privacy module 180 may be configured to calculate a root hash value and verify a root hash value against a signed root hash value of the utility 108.

The repository 124 is depicted separate from the customer device 104, the third party server 114, and the utility server 110, but is not limited to such an implementation. For example, in some embodiments, the repository 124 may include a storage module hosted on the customer device 104 and/or the utility server 110. Additionally or alternatively, the repository 124 may be included in or hosted by a trusted entity. In some embodiments, access to the energy usage data may be via a website, a computer application (e.g., a mobile application), or via a browser-based interface.

With reference to FIG. 1A, in the system 100 the utility 108 may distribute energy (e.g., electricity) to the site 128. Accordingly, data modified and communicated in the system 100 may include energy usage data. In some embodiments, the utility 108 may provide another resource such as natural gas or water to the site 128. Thus, in these embodiments, the data modified and communicated may include other types of data related to the resource, such as resource consumption.

One or more embodiments may be integrated into a customer-centric DR aggregation service, for example. Additionally, one or more embodiments may be integrated into other applications, besides DR aggregation services, that may be implemented on top of one or more embodiments of a customer-centric model discussed herein. Some services, such as sophisticated recommendation services, may use statistical or machine-learning techniques, which may include different privacy-preservation schemes. Another direction may include implementation of one or more disclosed embodiments in a user interface that assists customers' decision making to appropriately balance privacy and enable or assist the customers to benefit from services.

Moreover, some embodiments may be applicable in other systems or environments. While the system 100 depicted in FIG. 1A includes communication of energy usage data, the system 100 is a particular example of an environment in which data may be communicated using the modified Merkle hash tree as described herein or similar data structure. The utility 108 is a particular example of a data issuer or a data source that may be implemented in the environment. The third party 120 is a particular example of a data verifier that may be implemented in the environment. The customer 102 is a particular example of a data subject that may be implemented in the environment. Alternatively, processes similar or identical to those described herein may be used for privacy preservation in environments in which there is sensitive time-series data such as personal wearable devices, medical diagnostics, automotive or vehicle data, insurance company communications, and the like.

Modifications, additions, or omissions may be made to the system 100 without departing from the scope of the present disclosure. Specifically, embodiments depicted in FIG. 1A include one customer 102, one customer device 104, one repository 124, one site 128, one utility 108, one utility server 110, one third party 120, and one third party server 114. However, the present disclosure applies to systems that may include one or more of the customers 102, one or more of the customer devices 104, one or more of the repositories 124, one or more of the sites 128, one or more of the utilities 108, one or more of the utility servers 110, one or more of the third parties 120, one or more of the third party servers 114, or any combination thereof.

Moreover, the separation of various components in the embodiments described herein is not meant to indicate that the separation occurs in all embodiments. It may be understood with the benefit of this disclosure that the described components may be integrated together in a single component or separated into multiple components.

In the system 100, memory included in each of the customer device 104, the utility server 110, and the third party server 114 may be substantially similar to the memory 182. Processors included in the customer device 104, the utility server 110, and the third party server 114 may be substantially similar to the processor 184. Additionally, one or more of the customer devices 104, the utility server 110, and the third party server 114 may include a communication unit substantially similar to the communication unit 186.

FIG. 1B illustrates an example implementation of the system 100 of FIG. 1A with a customer-centric system architecture 170. FIG. 1B further illustrates an example privacy-preserving management of energy usage data (e.g., blocks 150, 152, 154, 156, and 160) in the system 100. The management depicted in the system architecture 170 includes one or more entities (e.g., 102, 108, 120, and 124) of FIG. 1A and illustrates an example flow of information among the entities.

Energy usage data may originate at the customer 102 (e.g., at the site 128 associated with the customer 102, as measured by the smart meter 129 or other suitable meter). The energy usage data may include meter readings 150. In some embodiments, the meter readings 150 may be sent periodically (e.g., at 15-minute intervals) or in real time to the utility 108. The meter readings 150 may be communicated to the utility 108 regardless of whether the customer 102 and/or the third party 120 are interested in the energy usage data.

The customer 102 using the customer device 104 and/or the repository 124 may periodically download the energy usage data from the utility 108. Additionally or alternatively, the repository 124 may periodically or automatically download the energy usage data from the utility server 110 on behalf of the customer 102. The energy usage data downloaded from the utility server 110 may include signed energy usage data 152.

The signed energy usage data 152 may include the energy usage data, metadata (e.g., timestamps) associated with the energy usage data, information sufficient to reconstruct a modified Merkle hash tree used to enable verification and authentication of the signed energy usage data 152, or some combination thereof. For example, the signed energy usage data 152 may include information and data sufficient to verify a digital signature of the utility 108 on a root node of the modified Merkle hash tree and to enable reconstruction of the modified Merkle hash tree. The signed energy usage data 152 may include full resolution energy usage data without any redactions in some embodiments. In other embodiments, the signed energy usage data 152 may include some resolution lower than full resolution, as determined by the utility 108. For instance, the full resolution energy usage data collected by the utility 108 may include 15-minute interval data, but the utility 108 may provide signed energy usage data 152 that is 30-minute interval data or some other time interval data.

By including a signature in the signed energy usage data 152, the third party 120 or any other party that knows and trusts a public key of the utility 108 may be convinced that the signed energy usage data 152 has been provided by the utility server 110 and/or has not been fraudulently tampered with by the customer 102. The utility 108 may be issued a digital certificate from a trusted Certification Authority (CA), and the utility 108 may post the digital certificate publicly such as on a website of the utility 108.

The signed energy usage data 152 may be stored, at least temporarily, on the repository 124. The customer 102 using the customer device 104 may access and/or browse the signed energy usage data 152 stored on the repository 124. In some embodiments, the customer device 104 may access and/or browse the signed energy usage data 152 at any time. The access and/or control over the repository 124 may be possible via a dedicated client software and/or a web browser (e.g., the customer privacy module 106 and/or the repository privacy module 180 of FIG. 1A).

Using the customer device 104, the customer 102 may issue a data sharing request 160 to the repository 124. For example, at times in which the customer 102 intends to share some energy usage data with the third party 120, the customer 102 may use the customer device 104 to issue the data sharing request 160 to the repository 124.

In embodiments such as those in which the third party 120 includes a DR aggregator, the data sharing request 160 may be related to event information communicated to the customer device 104 by the utility server 110 or the third party server 114. The event information may include DR event duration, curtailment amounts, and the like. The event information may be communicated a day ahead, or a few hours ahead, for instance. Additionally or alternatively, the event information may also be communicated to the third party server 114. In response, the third party server 114 may also communicate an information request (not shown) that may indicate to the customer 102 a particular time period to include in the energy usage data communicated to the third party server 114. The particular time period may include the DR event and historical energy usage data.

In response to the data sharing request 160 being issued by the customer device 104, a down-sampled signed energy usage data (down-sampled data) 154 may be generated. The down-sampled data 154 may include a down-sampled version of the signed energy usage data 152. For instance, the portions of the signed energy usage data 152 that introduce a privacy issue to the customer may be a down-sampled version of the energy usage data 152. Additionally or alternatively, all portions of the signed energy usage data 152 may be down-sampled other than the data involved in a service provided by the third party server 114. Additionally or alternatively, all portions of the signed energy usage data 152 may be down-sampled including the data involved in the service provided by the third party server 114. For example, the customer 102 may send 30-minute interval data (where an original time interval is 15 minutes) for a DR event period and 1-hour interval data for a non-DR event period.

In some embodiments, the repository 124 may generate the down-sampled data 154. The down-sampled data 154 may be based on a pre-selected privacy policy. For example, using the customer device 104, the customer 102 may select a low level of privacy in which only portions of the signed energy usage data 152 including a particular pattern may be down-sampled. Additionally or alternatively, the down-sampled data 154 may include a minimal disclosure form of the signed energy usage data 152 provided by the utility 108 based on the data sharing request 160.

In some embodiments, the customer 102 may view the signed energy usage data 152 using the customer device 104. The customer 102 may then select portions of the signed energy usage data 152 to down-sample using the customer device 104. The customer device 104 may communicate a down-sample request 156 to the repository 124. The down-sample request 156 may include the one or more portions of the signed energy usage data 152 that the customer 102 wishes to down-sample. For example, using the customer device 104, the customer 102 may down-sample the portions thought to be irrelevant to a service performed by the third party 120 and/or the portions that may introduce a privacy issue to the customer 102. Based on the down-sample request 156, the repository 124 may generate the down-sampled data 154.

The down-sampled data 154 may then be communicated to the third party server 114. Based on the down-sampled data 154 and one or more other pieces of information, the third party server 114 may reconstruct a modified Merkle hash tree configured to enable verification and authentication of the down-sampled data 154. For example, despite the down-sampled portions, the third party 120 may ensure the energy usage data accurately represents energy usage over a particular time period. Based on the down-sampled data 154, the third party 120 may perform an analysis. Additionally, after the modified Merkle hash tree is reconstructed, the third party server 114 may verify the signature of the utility 108. Verifying the signature may allow the third party 120 to protect against malicious or fraudulent service requests.

In some embodiments, the utility 108 or the utility server 110 may still have access to original energy usage data corresponding to the signed energy usage data 152. The utility 108 or the utility server 110 may use signed energy usage data 152 for prediction, anomaly detection, and the like. In some circumstances, the customer 102 may agree to such access in advance. Thus, the system 100 may not affect a quality of services provided by the utility 108. Likewise, the customer device 104 may also have access to the signed energy usage data 152 to conduct data analytics. In some embodiments the repository 124 may include or support such functionality.

As mentioned above, a modified Merkle hash tree may be used for down-sampling and generation of redactable signatures used to verify and authenticate the energy usage data. The modified Merkle hash tree may be similar to a traditional Merkle hash tree. In a traditional Merkle hash tree, each parent node generally includes a hash of a concatenation of each of its child nodes. In the modified Merkle hash tree as described herein, each parent node is based on a hash of (1) a sum of all data values pertaining to the corresponding parent node and (2) a hash of a concatenation of each of its child nodes.

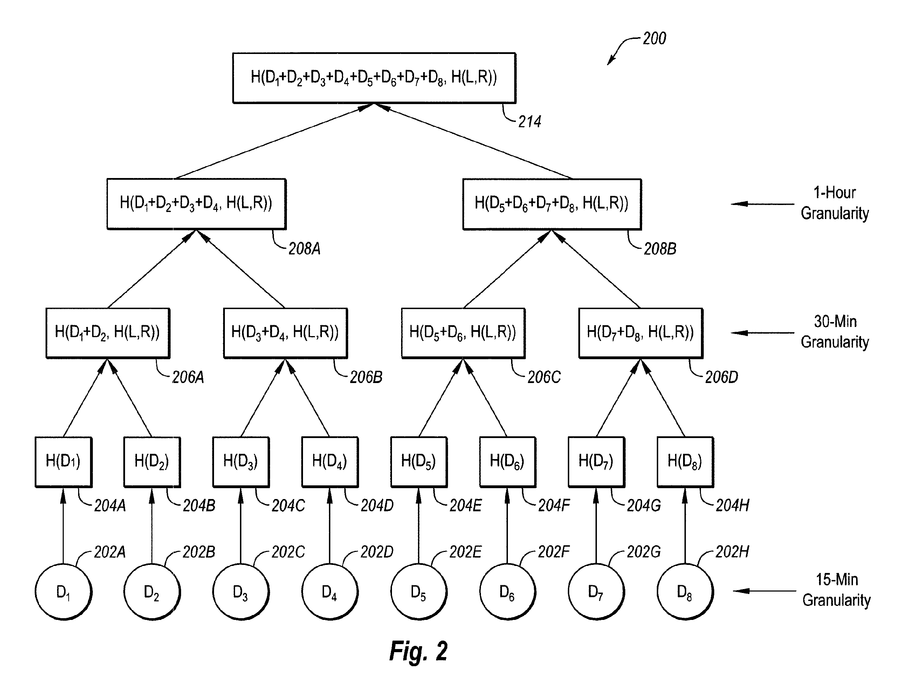

For example, FIG. 2 depicts an example modified Merkle hash tree 200 that may be implemented in the system 100 of FIGS. 1A and 1B, arranged in accordance with at least one embodiment described herein. For example, the utility 108 may construct the modified Merkle hash tree 200 to calculate a root hash value for a root node 214. A digital signature of the utility 108 may be made on the root hash value calculated for the root node 214. Additionally, the modified Merkle hash tree 200 may be used by the repository 124 and or the customer device 104 to down-sample the energy usage data. Moreover, the modified Merkle hash tree 200 may be reconstructed by the third party server 114 from down-sampled energy usage data. Based on the reconstructed modified Merkle hash tree 200, the third party 120 may verify the source of the energy usage data (e.g., via the digital signature) and authenticate the down-sampled energy usage data (e.g., via appropriate hash values included with the down-sampled data and the digital signature).

The modified Merkle hash tree 200 may include a root node 214, intermediate nodes 206A-206D, 208A, and 208B (generally, intermediate node 206, 208 or intermediate nodes 206, 208), leaf nodes 204A-204H (generally, leaf node 204 or leaf nodes 204), and data blocks 202A-202H (generally, data block 202 or data blocks 202). The root node 214 and the intermediate nodes 206, 208 may also be referred to as non-leaf nodes 214, 208, 206 or parent nodes 214, 208, 206 (since each is a parent node to two corresponding leaf nodes 204 or two corresponding intermediate nodes 208, 206). Generally, the modified Merkle hash tree 200 includes a tree structure in which each node (214, 208, 206, and 204) stores a hash of some data or data blocks 202.

The modified Merkle hash tree 200 may represent a particular data set including energy usage data over a particular time period. FIG. 2 illustrates one non-limiting example of a modified Merkle hash tree 200 for a data set including eight data values or data measurements $D_1$ - $D_8$ included in the data blocks 202. In this example, the eight data blocks 202 may include data values that represent electricity consumption measured in 15 minute intervals. Thus, in this example the data blocks 202 may have energy usage data measured in 15 minute intervals or with 15 minute granularity. However, it is understood that other examples may include any number of data blocks 202 representing measurements for any time period, interval, or granularity. Furthermore, although the example modified Merkle hash tree 200 of FIG. 2 is shown as a binary tree, it is understood that other example modified Merkle hash trees may not be binary such that parent nodes 206, 208 may have one leaf node 204, or more than two leaf nodes 204. Accordingly, the tree structure of the modified Merkle hash tree 200 may be N-ary, where N is greater than or equal to 1. The tree structure of the modified Merkle Hash tree, and more particularly the value of N for any N-ary implementation, may generally be agreed upon among at least the customer 102 and the third party 120.

A root hash value may be calculated by the utility 108 for the data blocks 202 of FIG. 2 as follows and then signed by the utility 108. First, the utility 108 may identify a time period and all data measurements pertaining to the time period. The utility 108 may then sequentially sort the data measurements for the identified time period to prepare the time-series data for root hash calculation and digital signature. The data blocks 202 may be associated with metadata, including timestamps, in order to facilitate sequential sorting of the data blocks 202. In this example, the data blocks 202 correspond to eight 15 minute data measurement intervals that span a two hour time period. The utility 108 may then calculate hash values for each data measurement $D_1$-$D_8$ of each data block 202, and store the hash values in corresponding leaf nodes 204. The utility 108 may calculate hash values for each data measurement $D_1$-$D_8$ of each data block 202 by input of each data measurement $D_1$-$D_8$ into a hash function, which hash function outputs a corresponding hash value. The hash function may include SHA-2 or other stronger hash function in some embodiments.

After the hash values of the data blocks 202 are calculated for the leaf nodes 204, common parent node hash values $H_P$ of the parent nodes 206, 208, and the root node 214 may be calculated according to a common hash value equation:

$$H_P = H(D_S, H(L,R)).$$

In the common hash value equation, a variable $D_S$ represents a sum of all data values pertaining to a common parent node (e.g., a sum of all measurements covered by the common parent node). For example, $D_S$ for the common parent node 206A may include $D_1$+$D_2$ (e.g., data blocks 202A and 202B), $D_S$ for the common parent node 208A may include $D_1$+$D_2$+$D_3$+$D_4$ (e.g., data blocks 202A-202D), and $D_S$ for the common parent node 214 may include $D_1$+$D_2$+$D_3$+$D_4$+$D_5$+$D_6$+$D_7$+$D_8$ (e.g., data blocks 202A-202H), etc., as may be seen in FIG. 2. $H(L,R)$ in the common hash value equation includes a hash value generated by hashing a concatenation of hash values of child nodes, such as the left L and right R child hash values, of the common parent node. More particularly, $H(L,R)$ is a hash value output by a hash function that receives a concatenation of hash values of child nodes of the corresponding common parent node as its input. Accordingly, each common parent node hash value $Hp$ may be calculated by hashing $D_S$ and $H(L,R)$. More particularly, each common parent node hash value $H_P$ for a corresponding common parent node is output by a hash function that receives $D_S$ and $H(L,R)$ corresponding to the common parent node as its input.

Thus, modification to the data measurements or the order of the data measurements may be prevented by basing each common parent node hash value on both (1) $D_S$ (e.g., a sum of all data values pertaining to the corresponding parent node) and (2) $H(L,R)$ (e.g., a hash of a concatenation of each of its child nodes). After the hash value of the root node 214 has been calculated, the hash value of the root node 214 may be digitally signed by the utility 108. The utility 108 may then send the digitally signed root hash value and data blocks 202 to the customer 102.

In some embodiments, the modified Merkle hash tree or other data structure described herein may be further modified to secure customer data, e.g., against brute force attacks. For example, hash values may be calculated based on a per-customer key that is unique to the customer, a keyed hash function, an initialization vector, and a counter. Additional details of the foregoing are described in the U.S. Patent Application No.: 14/498,942.

The customer 102 may download, or otherwise receive, the digitally signed root hash value and data blocks 202 from the utility 108. The customer 102 may decide to share this energy usage data with a third party 120 by selecting a granularity level to use for sharing the energy usage data with the third party 120 according to the selected granularity level. In this example, the customer 102 may select a 15 minute granularity level (highest resolution), a 30 minute granularity level, a 1 hour granularity level, or a 2 hour granularity level. If the customer 102 desires to share 15 minute granularity data with the third party 120, the customer 102 may send the digitally signed root hash value and the eight non-down-sampled 15 minute granularity values ($D_1$, $D_2$, $D_3$, $D_4$, $D_5$, $D_6$, $D_7$, and $D_8$) directly to the third party 120.

As another example, if the customer 102 desires to share 30 minute granularity data with the third party 120, the customer 102 may send the digitally signed root hash value to the third party 120 along with four 30 minute granularity down-sampled values summed as follows: ($D_1$+$D_2$), ($D_3$+$D_4$), ($D_5$+$D_6$), ($D_7$+$D_8$). In this case, the customer 102 may also send the hash values of the child nodes corresponding to the down-sampled energy usage data, which are: $H(D_1)$, $H(D_2)$, $H(D_3)$, $H(D_4)$, $H(D_5)$, $H(D_6)$, $H(D_7)$, and $H(D_8)$.

As yet another example, if the customer 102 desires to share 1 hour granularity data with the third party 120, the customer 102 may send the digitally signed root hash value with two 1 hour granularity down-sampled values summed as follows: ($D_1$+$D_2$+$D_3$+$D_4$), ($D_5$+$D_6$+$D_7$+$D_8$). In this case, the customer 102 may also send the hash values of the child nodes pertaining to the aggregated data values, which are: $H(D_1$+$D_2$, $H(L,R))$, $H(D_3$+$D_4$, $H(L,R))$, $H(D_5$+$D_6$, $H(L,R))$, and $H(D_7$+$D_8$, $H(L,R))$.

As yet another example, if the customer 102 desires to share 2 hour granularity data with the third party 120, the customer 102 may send the digitally signed root hash value with one 2 hour granularity down-sampled value summed as follows: ($D_1$+$D_2$+$D_3$+$D_4$+$D_5$+$D_6$+$D_7$+$D_8$). In this case, the customer 102 may also send the hash values of the child nodes pertaining to the aggregated data values, which are: $H(D_1+D_2+D_3+D_4, H(L,R))$ and $H(D_5+D_6+D_7+D_8, H(L,R))$.

In some embodiments, the customer 102 may send energy usage data with two or more different granularity levels or down-sampling rates. For example, the customer 102 may send data to a third party 120 with a higher sampling rate for demand response periods and a lower sampling rate for other time periods. As one non-limiting example of this embodiment, the customer 102 may send the digitally signed root hash value with four of the eight non-down-sampled 15 minute granularity values: $D_1, D_2, D_3, D_4$, plus two of the four 30 minute granularity down-sampled values $(D_5+D_6)$ and $(D_7+D_8)$. In this case, the customer 102 may also send the hash values of the child nodes pertaining to the aggregated down-sampled values, in this case: $H(D_5)$, $H(D_6)$, $H(D_7)$, and $H(D_8)$.

In other embodiments, the customer 102 may send down-sampled energy usage data with a redacted data block or one or more redacted data blocks or data values. The customer 102 may select a data block, two sequential data blocks, or a section of data blocks for redaction and the selected data block, the two sequential data blocks, and/or the selected section of data blocks may be redacted such that the redacted section is removed. As one non-limiting example of this embodiment, the customer 102 may send the digitally signed root hash value with two of the four 30 minute granularity down-sampled values $(D_3+D_4)$ and $(D_5+D_6)$ while redacting the other two 30 minute granularity down-sampled values $(D_1+D_2)$ and $(D_7+D_8)$. In this case, the customer 102 may also send the following hash values: $H(D_1+D_2, H(L,R))$, $H(D_3)$, $H(D_4)$, $H(D_5)$, $H(D_6)$, and $H(D_7+D_8, H(L,R))$.

A third party 120 may receive any of the above described energy usage data examples for each of the different embodiments and then reconstruct the modified Merkle hash tree to find the root hash value and verify the data. The third party 120 may use this root hash value for comparison against the digitally signed root hash value of the utility 108 in order to verify and authenticate the energy usage data received from the customer 102. The third party 120 may accomplish this process by loading all of the data and hash values provided by the customer 102 into a partially reconstructed modified Merkle hash tree, then calculate remaining hash values for any parent nodes that lie between the provided hash values and the root node 214. The third party 120 may then calculate the hash value of the root node 214 using the hash values of its child nodes. The third party 120 may then compare this root hash value against the utility's digital signature to verify the energy usage data.

Reconstructing the Merkle hash tree in this manner enables the third party 120 to detect fraudulent energy usage data sent by malicious customers 102. For example, if a malicious customer 102 sends the following data: $\{X, (D_3+D_4), (D_5+D_6), (D_7+D_8)\}$, where "X" has been changed and does not equal the summation of the orig-

inal data values $(D_1+D_2)$, then upon reconstructing the Merkle hash tree one level above these data values produces a hash value of $H(X+3+4, H(L', R))$. This hash value would propagate to the root hash value and result in a root hash value that is different from the digitally signed root hash value received from the utility 108. Likewise, if a malicious customer 102 tries to rearrange the order of the data values by sending the following data: $\{(3+4), (1+2), (5+6), (7+8)\}$, then upon reconstructing the Merkle hash tree one level above these data values produces a hash value of $H(3+4+1+2, H(R, L))$. This hash value would also propagate and result in a calculated root hash value that is different from the digitally signed root hash value received from the utility 108. Thus, any changes to the values of the data or the order of the data may be detected by the third party 120.

The down-sampled data 154 may then be communicated to the third party server 114. Based on the down-sampled data 154 and one or more other pieces of information, the third party server 114 may reconstruct a modified Merkle hash tree configured to enable verification and authentication of the down-sampled data 154. For example, despite the down-sampled portions, the third party 120 may ensure the energy usage data accurately represents energy usage over a particular time period. Based on the down-sampled data 154, the third party 120 may perform an analysis. Additionally, after the modified Merkle hash tree is reconstructed, the third party server 114 may verify the signature of the utility 108. Verifying the signature may allow the third party 120 to protect against malicious or fraudulent service requests.

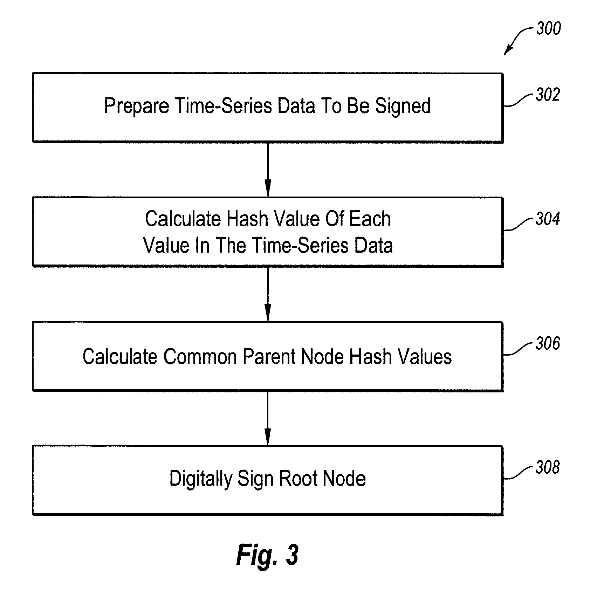

FIG. 3 is a flow diagram of an example method 300 of generating digitally-signed time-series data, arranged in accordance with at least one embodiment described herein. The digitally-signed time-series data may be down-sampled while still permitting verification and authentication of the down-sampled data. The method 300 may be implemented, in whole or in part, by one or more of the utility server 110 or the system 100 of FIGS. 1A or 1B, or another suitable device, server, and/or system. The method 300 may begin at block 302.

In block 302 ("Prepare Time-Series Data To Be Signed"), time-series data may be prepared to be digitally signed. The time-series data may include energy usage data. Preparing the time-series data to be digitally signed may include sorting individual data values of the time-series data sequentially according to corresponding timestamps. Block 302 may be followed by blocks 304 and 306.

In general, blocks 304 and 306 may include generating a data structure that includes multiple leaf nodes, multiple common parent nodes, and a root node. In more detail, in block 304 ("Calculate Hash Value Of Each Value In The Time-Series Data"), the leaf nodes may be calculated by calculating a hash value of each individual data value or data block in the time-series data. For example, in the context of FIG. 2, calculating the hash value of each individual data value in the time-series data may include calculating the hash values $H(D_1)$ - $H(D8)$ of the individual data values $D_1$ - $D_8$ included in the data blocks 202. Block 304 may be followed by block 306.

In block 306 ("Calculate Common Parent Node Hash Values"), the common parent nodes may be calculated by, for each common parent node, calculating a corresponding common parent node hash value. Each common parent node hash value may be calculated according to the common hash value equation above, e.g., based on both (1) $D_S$ (e.g., a sum of all data values pertaining to the corresponding parent node) and (2) $H(L,R)$ (e.g., a hash of a concatenation of each of its child nodes). For example, in the context of FIG. 2, the common parent node hash value for parent node 206A may be calculated as $H(D_1+D_2, H(L,R))$, the common parent node hash value for parent node 208A may be calculated as $H(D_1+D_2+D_3+D_4, H(L,R))$, the common parent node hash value (or root hash value) for root node 214 may be calculated as $H(D_1+D_2+D_3+D_4+D_5+D_6+D_7+D_8, H(L,R))$, and so on.

In block 308 ("Digitally Sign Root Node"), the root node may be digitally signed to generate a digital signature of the energy usage data from the root node and a private key of a corresponding data issuer. The root node may include a root hash value. For instance, in the context of FIG. 2, the root node may include the root node 214, which includes root hash value $H(D_1+D_2+D_3+D_4+D_5+D_6+D_7+D_8, H(L,R))$. The root node may be digitally signed using the private key of the corresponding data issuer, such as the private key of the utility 108 of FIGS. 1A-1B.

The method 300 of FIG. 3 may generate digitally-signed time-series data whose integrity and authenticity may be verified even after being down-sampled. For example, after down-sampling of the time-series data including aggregating two or more individual data values into one or more aggregated data values, an integrity and authenticity of the down-sampled time-series data may be verifiable with the digital signature, the aggregated data values, the down-sampled time-series data, hash values of child nodes corresponding to the down-sampled time-series data, and a public key of the data issuer that corresponds to the private key. Additionally, the integrity and authenticity of the down-sampled time-series data may be verifiable without the individual data values aggregated into the aggregated data values.

One skilled in the art will appreciate that, for this and other processes and methods disclosed herein, the functions performed in the processes and methods may be implemented in differing order. Furthermore, the outlined steps and operations are only provided as examples, and some of the steps and operations may be optional, combined into fewer steps and operations, or expanded into additional steps and operations without detracting from the essence of the disclosed implementations.

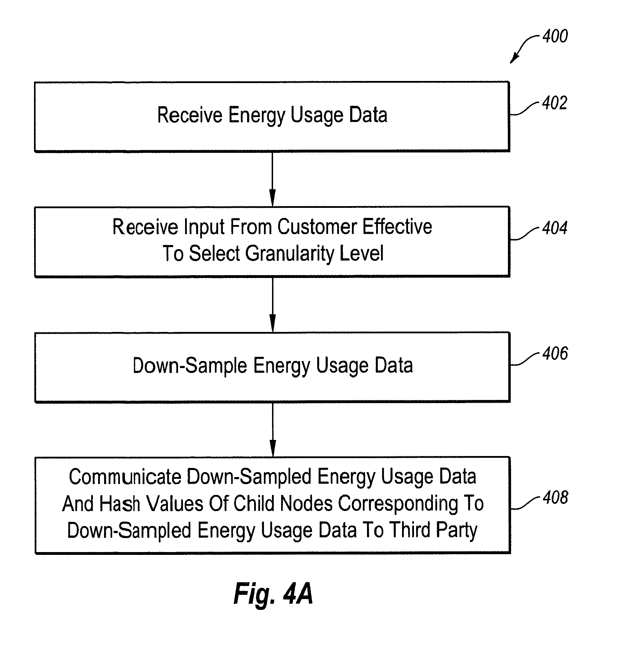

FIG. 4A is a flow diagram of an example method 400 of down-sampling time-series data, arranged in accordance with at least one embodiment described herein. The method 400 may be implemented, in whole or in part, by one or more of the customer device 104, the repository 124, the system 100 of FIGS. 1A or 1B, or another suitable device, server, and/or system. In FIG. 4A, the time-series data includes energy usage data. However, the method 400 may more generally be applied with any time-series data. The method 400 may begin at block 402.

In block 402 ("Receive Energy Usage Data"), energy usage data may be received. The energy usage data may be representative of energy usage of a customer during a particular time period. The energy usage data may also be signed with a digital signature of a data issuer, such as a utility. Block 402 may be followed by block 404.

In block 404 ("Receive Input From Customer Effective To Select Granularity Level"), input from a customer may be received that is effective to select a granularity level to apply to the energy usage data. For example, if the energy usage data is represented in 15 minute increments, the customer may select another granularity level to apply to the energy usage data before sharing the energy usage data with a third party (e.g., a 30 minute or 1 hour granularity level). Block 404 may be followed by block 406.

In block 406 ("Down-Sample Energy Usage Data"), the energy usage data may be down-sampled to apply the selected granularity level to the energy usage data. This process may produce down-sampled energy usage data corresponding to the selected granularity level. Block 406 may be followed by block 408.

In block 408 ("Communicate Down-Sampled Energy Usage Data And Hash Values Of Child Nodes Corresponding To Down-Sampled Energy Usage Data To Third Party"), the down-sampled energy usage data may be communicated to a third party. Additionally, hash values of child nodes corresponding to the down-sampled energy usage data may also be communicated to the third party.

Optionally, the method 400 may include fewer operations than are illustrated in FIG. 4A and/or additional operations not illustrated in FIG. 4A. For example, prior to down-sampling the energy usage data and communicating the down-sampled energy usage data and hash values to the third party, the method 400 may additionally include one or more operations associated with redaction of one more data blocks from the energy usage data. More particularly, the method 400 may include receiving input from the customer that is effective to select a data block of the energy usage data for redaction. The selected data block may be redacted from the energy usage data in response to the input of the customer. A hash value for the redacted data block may be calculated. The redacted data block in the energy usage data may be replaced with the calculated hash value corresponding to the redacted data block. In this and other embodiments, block 408 may include communicating down-sampled and redacted energy usage data, hash values of child nodes corresponding to down-sampled energy usage data, and the hash value (or hash values) of the redacted data block (or of multiple redacted data blocks) to the third party.

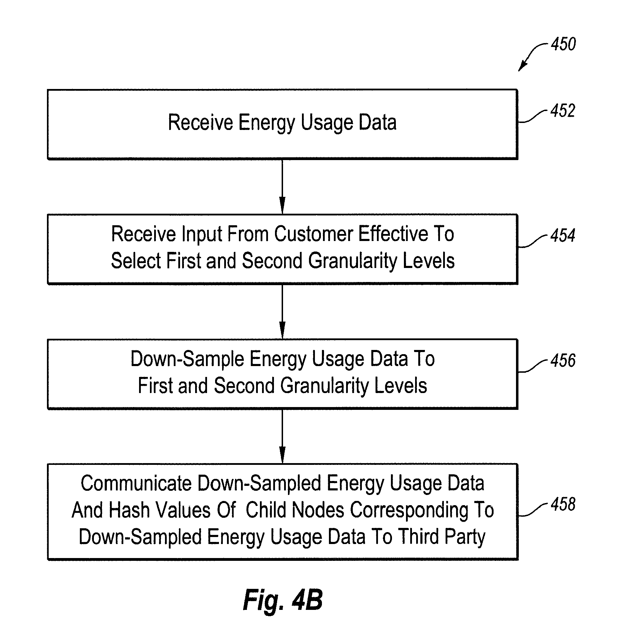

FIG. 4B is a flow diagram of another example method 450 of down-sampling time-series data, arranged in accordance with at least one embodiment described herein. The method 450 may be implemented, in whole or in part, by one or more of the customer device 104, the repository 124, the system 100 of FIGS. 1A or 1B, or another suitable device, server, and/or system. In FIG. 4B, the time-series data includes energy usage data. However, the method 450 may more generally be applied with any time-series data. The method 450 may begin at block 452.

In block 452 ("Receive Energy Usage Data"), energy usage data may be received. The energy usage data may be representative of energy usage of a customer during a particular time period. The energy usage data may also be signed with a digital signature of a data issuer, such as a utility. Block 452 may be followed by block 454.

In block 454 ("Receive Input From Customer Effective To Select First And Second Granularity Levels"), input from a customer may be received that is effective to select a first granularity level and a second granularity level to apply to the energy usage data. For example, if the energy usage data is represented in 15 minute increments, the customer may select a first granularity level to apply to the energy usage data (e.g., a 30 minute granularity level) and a second granularity level to apply to the energy usage data (e.g., a 1 hour granularity level) before sharing the energy usage data with a third party. The first and second granularity levels may be selected for application to different portions of the energy usage data. Block 454 may be followed by block 456.

In block 456 ("Down-Sample Energy Usage Data To First And Second Granularity Levels"), the energy usage data may be down-sampled to the first and second granularity levels to apply the selected granularity levels to the energy usage data. This process may produce different down-sampled energy usage data corresponding to the selected granularity levels. Block 456 may be followed by block 458.

In block 458 ("Communicate Down-Sampled Energy Usage Data And Hash Values Of Child Nodes Corresponding To Down-Sampled Energy Usage Data To Third Party"), the down-sampled energy usage data may be communicated to a third party. Additionally, hash values of child nodes corresponding to the down-sampled energy usage data may also be communicated to the third party.

Optionally, the method 450 may include fewer operations than are illustrated in FIG. 4B and/or additional operations not illustrated in FIG. 4B. For example, prior to down-sampling the energy usage data and communicating the down-sampled energy usage data and hash values to the third party, the method 450 may include one or more operations associated with redaction of one or more data blocks from the energy usage data. More particularly, the method 450 may additionally include receiving input from the customer that is effective to select a data block of the energy usage data for redaction. The selected data block may be redacted from the energy usage data in response to the input received from the customer. A hash value for the redacted data block may be calculated. The redacted data block in the energy usage data may be replaced with the calculated hash value corresponding to the redacted data block. In this and other embodiments, block 458 may include communicating down-sampled and redacted energy usage data, hash values of child nodes corresponding to down-sampled energy usage data, and the hash value (or hash values) of the redacted data block (or of multiple redacted data blocks) to the third party.

In some embodiments, the energy usage data may be reconstructed using a modified Merkle hash tree as described herein. The utility may sign the root node of the modified Merkle hash tree. In these and other embodiments, the data blocks include energy usage data from meter readings and metadata associated with the meter readings and down-sampling and/or redaction of the data blocks does not affect the root node.

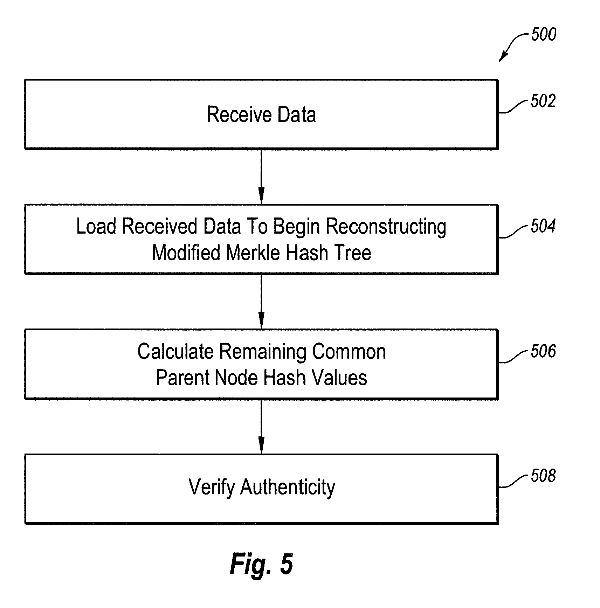

FIG. 5 is a flow diagram of an example method 500 of verifying down-sampled time-series data, arranged in accordance with at least one embodiment described herein. The method 500 may be implemented, in whole or in part, by one or more of the third party server 114 or the system 100 of FIGS. 1A or 1B, or another suitable device, server, and/or system. The method 500 may begin at block 502.

In block 502 ("Receive Data"), a digitally-signed root node (e.g., digitally-signed root hash value), down-sampled time-series data, and one or more associated hash values may be received. The hash values that are received may generally depend on which of multiple original time-series data values are down-sampled, as already described above. Block 502 may be followed by block 504.

In block 504 ("Load Received Data To Begin Reconstructing Modified Merkle Hash Tree"), at least some of the received data may be loaded into a modified Merkle hash tree to begin reconstruction of the modified Merkle hash tree. For example, in the context of FIG. 2, the received data may include down-sampled data or aggregated data values $(D_1+D_2+D_3+D_4)$ and $(D_5+D_6+D_7+D_8)$ and hash values $H(D_1+D_2, H(L,R))$, $H(D_3+D_4, H(L,R))$, $H(D_5+D_6, H(L,R))$, and $H(D_7+D_8, H(L,R))$ of the child nodes pertaining to the aggregated data values. In this example, the hash values $H(D_1+D_2, H(L,R))$, $H(D_3+D_4, H(L,R))$, $H(D_5+D_6, H(L,R))$, and $H(D_7+D_8, H(L,R))$ may be loaded into common parent nodes 206 and the aggregated data values $(D_1+D_2+D_3+D_4)$ and $(D_5+D_6+D_7+D_8)$ for calculation of common parent nodes 208. Block 504 may be followed by block 506.

In block 506 ("Calculate Remaining Common Node Parent Hash Values"), any remaining common parent node hash values of the modified Merkle hash tree being reconstructed may be calculated. Continuing with the foregoing example involving FIG. 2, the common parent node hash values of common parent nodes 208 may be calculated with the loaded data from block 504, followed by calculation of the root hash value included in the root hash node 214. Block 506 may be followed by block 508.

In block 508 ("Verify Authenticity"), the authenticity of the down-sampled time-series data may be verified. Verifying the authenticity may include comparing the calculated root hash value against a digital signature (e.g., the digitally-signed root node or root hash value) of a data issuer.

The embodiments described herein may include the use of a special-purpose or general-purpose computer including various computer hardware or software modules, as discussed in greater detail below.

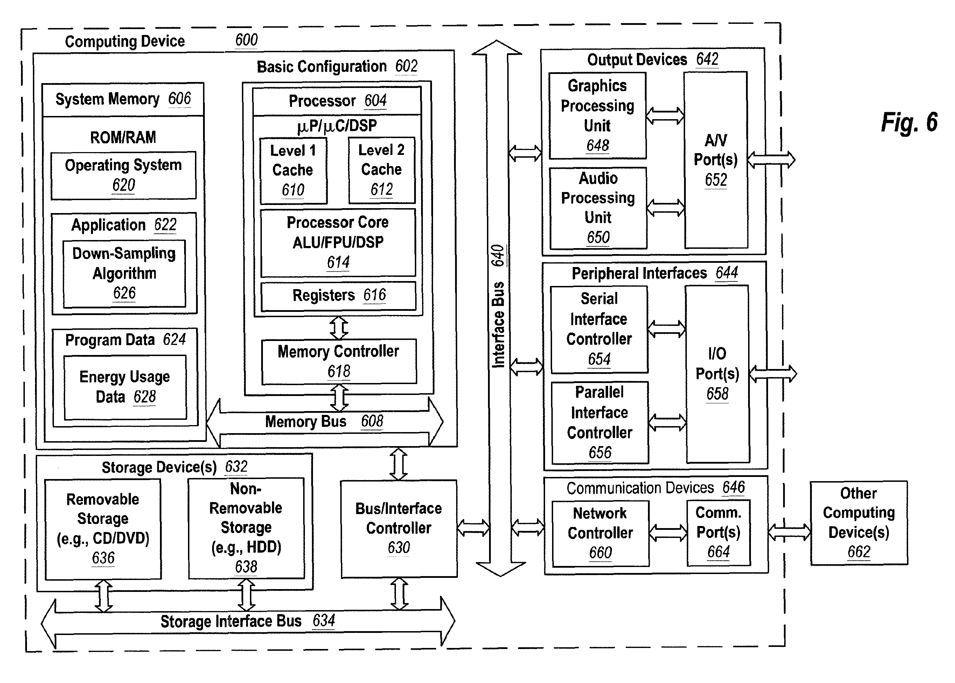

FIG. 6 is a block diagram illustrating an example computing device 600 that is arranged for down-sampling and/or redaction of time-series data, arranged in accordance with at least one embodiment described herein. In a basic configuration 602, the computing device 600 typically includes one or more processors 604 and a system memory 606. A memory bus 608 may be used for communicating between the processor 604 and the system memory 606.

Depending on the desired configuration, the processor 604 may be of any type including, but not limited to, a microprocessor (μP), a microcontroller (μC), a digital signal processor (DSP), or any combination thereof. The processor 604 may include one or more levels of caching, such as a level one cache 610 and a level two cache 612, a processor core 614, and registers 616. The processor core 614 may include an arithmetic logic unit (ALU), a floating point unit (FPU), a digital signal processing core (DSP Core), or any combination thereof. An example memory controller 618 may also be used with the processor 604, or in some implementations the memory controller 618 may be an internal part of the processor 604.

Depending on the desired configuration, the system memory 606 may be of any type including, but not limited to, volatile memory (such as RAM), nonvolatile memory (such as ROM, flash memory, etc.), or any combination thereof. The system memory 606 may include an operating system 620, one or more applications 622, and program data 624. The application 622 may include a down-sampling algorithm 626 that is arranged to perform down-sampling of time-series data as is described herein. The program data 624 may include energy usage data 628 as is described herein, or other time-series data. In some embodiments, the application 622 may be arranged to operate with the program data 624 on the operating system 620 such that the methods 400 and 450 of FIGS. 4A and 4B may be provided as described herein.

The computing device 600 may have additional features or functionality, and additional interfaces to facilitate communications between the basic configuration 602 and any involved devices and interfaces. For example, a bus/interface controller 630 may be used to facilitate communications between the basic configuration 602 and one or more data storage devices 632 via a storage interface bus 634. The data storage devices 632 may be removable storage devices 636, non-removable storage devices 638, or a combination thereof. Examples of removable storage and non-removable storage devices include magnetic disk devices such as flexible disk drives and hard-disk drives (HDDs), optical disk drives such as compact disk (CD) drives or digital versatile disk (DVD) drives, solid state drives (SSDs), and tape drives to name a few. Example computer storage media may include volatile and nonvolatile, removable and non-removable media implemented in any method or technology for storage of information, such as computer-readable instructions, data structures, program modules, or other data.

The system memory 606, the removable storage devices 636, and the non-removable storage devices 638 are examples of computer storage media or non-transitory computer-readable medium or media. Computer storage media or non-transitory computer-readable media includes RAM, ROM, EEPROM, flash memory or other memory technology, CD-ROM, digital versatile disks (DVDs) or other optical storage, magnetic cassettes, magnetic tape, magnetic disk storage or other magnetic storage devices, or any other medium which may be used to store the desired information and which may be accessed by the computing device 600. Any such computer storage media or non-transitory computer-readable media may be part of the computing device 600.

The computing device 600 may also include an interface bus 640 for facilitating communication from various interface devices (e.g., output devices 642, peripheral interfaces 644, and communication devices 646) to the basic configuration 602 via the bus/interface controller 630. The output devices 642 include a graphics processing unit 648 and an audio processing unit 650, which may be configured to communicate to various external devices such as a display or speakers via one or more A/V ports 652. The peripheral interfaces 644 include a serial interface controller 654 or a parallel interface controller 656, which may be configured to communicate with external devices such as input devices (e.g., keyboard, mouse, pen, voice input device, touch input device, etc.), sensors, or other peripheral devices (e.g., printer, scanner, etc.) via one or more I/O ports 658. The communication devices 646 include a network controller 660, which may be arranged to facilitate communications with one or more other computing devices 662 over a network communication link via one or more communication ports 664.

The network communication link may be one example of a communication media. Communication media may typically be embodied by computer-readable instructions, data structures, program modules, or other data in a modulated data signal, such as a carrier wave or other transport mechanism, and may include any information delivery media. A "modulated data signal" may be a signal that has one or more of its characteristics set or changed in such a manner as to encode information in the signal. By way of example, and not limitation, communication media may include wired media such as a wired network or direct-wired connection, and wireless media such as acoustic, radio frequency (RF), microwave, infrared (IR), and other wireless media. The term "computer-readable media" as used herein may include both storage media and communication media.

The computing device 600 may be implemented as a portion of a small-form factor portable (or mobile) electronic device such as a smartphone, a personal data assistant (PDA), or an application-specific device. The computing device 600 may also be implemented as a personal computer including both laptop computer and non-laptop computer configurations, or a server computer including both rack-mounted server computer and blade server computer configurations.

Embodiments described herein may be implemented using computer-readable media for carrying or having computer-executable instructions or data structures stored thereon. Such computer-readable media may be any available media that may be accessed by a general-purpose or special-purpose computer. By way of example, and not limitation, such computer-readable media may include non-transitory computer-readable storage media including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices), or any other storage medium which may be used to carry or store desired program code in the form of computer-executable instructions or data structures and which may be accessed by a general-purpose or special-purpose computer. Combinations of the above may also be included within the scope of computer-readable media.

Computer-executable instructions may include, for example, instructions and data which cause a general-purpose computer, special-purpose computer, or special-purpose processing device (e.g., one or more processors) to perform a certain function or group of functions. Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

As used herein, the terms "module" or "component" may refer to specific hardware implementations configured to perform the operations of the module or component and/or software objects or software routines that may be stored on and/or executed by general-purpose hardware (e.g., computer-readable media, processing devices, etc.) of the computing system. In some embodiments, the different components, modules, engines, and services described herein may be implemented as objects or processes that execute on the computing system (e.g., as separate threads). While some of the system and methods described herein are generally described as being implemented in software (stored on and/or executed by general-purpose hardware), specific hardware implementations or a combination of software and specific hardware implementations are also possible and contemplated. In this description, a "computing entity" may be any computing system as previously defined herein, or any module or combination of modulates running on a computing system.

All examples and conditional language recited herein are intended for pedagogical objects to aid the reader in understanding the invention and the concepts contributed by the inventor to furthering the art, and are to be construed as being without limitation to such specifically recited examples and conditions. Although embodiments of the present inventions have been described in detail, various changes, substitutions, and alterations could be made hereto without departing from the spirit and scope of the invention.

## Claims

1. A method to down-sample time-series data that includes energy usage data, the method comprising:

   receiving energy usage data representative of energy usage of a customer during a specified period, the energy usage data being signed with a digital signature of a utility;
   receiving input from a customer effective to select a granularity level to apply to the energy usage data;
   down-sampling the energy usage data to apply the selected granularity level to the energy usage data and produce down-sampled energy usage data; and
   communicating the down-sampled energy usage data and hash values of child nodes corresponding to the down-sampled energy usage data to a third party.

2. The method of claim 1, wherein the down-sampling comprises aggregating data values pertaining to a common parent node.

3. The method of claim 2, further comprising:

   receiving input from a customer effective to select a data block of the energy usage data; redacting a selected data block from the energy usage data in response to the input; calculating a hash value for the redacted data block; and replacing, in the energy usage data, the redacted data block with the calculated hash value corresponding to the redacted data block.

4. The method of claim 3, wherein the hash value for the redacted data block is calculated using at least one of a per-customer key that is unique to the customer, an initialization vector, or a counter.

5. The method of claim 1, further comprising:

receiving input from a customer effective to select a section of data blocks of the energy usage data, the selected section of data blocks including first and second data blocks with a common parent node, wherein the first and second data blocks are sequential; redacting the selected section of data blocks from the energy usage data in response to the input; calculating hash values for the first and second data blocks in the selected section of data blocks; calculating a parent hash value for the common parent node based on a concatenation of hash values of the first and second data blocks; and replacing the selected section with the parent hash value.

6. The method of claim 5, further comprising communicating to the third party the energy usage data including the parent hash value as a replacement for the selected section.

7. The method of claim 5, wherein the parent hash value for the common parent node is calculated according to an equation:

$$H_P = H(D_S, H(L,R))$$

in which:

$D_S$ represents a sum of all data values pertaining to the common parent node, the data values pertaining to the common parent node including data values of the first and second data blocks; $H(L,R)$ includes a hash value based on a concatenation of hash values of child nodes of the common parent node, the child nodes including the hash values of the first and second data blocks; and

$H(D_S, H(L,R))$ includes a hash of $D_S$ and $H(L,R)$.

8. The method of claim 1, wherein:

the receiving input comprises receiving input effective to select a first granularity level and a different second granularity level to apply to the energy usage data; and the down-sampling comprises down-sampling the energy usage data to produce down-sampled energy usage data at the first granularity level and the different second granularity level.

9. A device to down-sample time-series data that includes energy usage data, the device comprising:

a non-transitory computer-readable medium having computer instructions stored thereon; and a processor communicatively coupled to the non-transitory computer-readable medium and configured to execute the computer instructions to perform or control performance of operations comprising:

receiving energy usage data representative of energy usage of a customer during a specified period, the energy usage data being signed with a digital signature of a utility; receiving input from a customer effective to select a granularity level to apply to the energy usage data; down-sampling the energy usage data to apply the selected granularity level to the energy usage data and produce down-sampled energy usage data; and communicating the down-sampled energy usage data and hash values of child nodes corresponding to the down-sampled energy usage data to a third party.

10. The device of claim 9, wherein the down-sampling comprises aggregating data values pertaining to a common parent node.

11. The device of claim 10, the operations further comprising:

receiving input from a customer effective to select a data block of the energy usage data; redacting a selected data block from the energy usage data in response to the input; calculating a hash value for the redacted data block; and replacing, in the energy usage data, the redacted data block with the calculated hash value corresponding to the redacted data block.

**12.** The device of claim 11, wherein the hash value for the redacted data block is calculated using at least one of a per-customer key that is unique to the customer, an initialization vector, or a counter.

**13.** The device of claim 9, the operations further comprising:

receiving input from a customer effective to select a section of data blocks of the energy usage data, the selected section of data blocks including first and second data blocks with a common parent node, wherein the first and second data blocks are sequential;
redacting the selected section of data blocks from the energy usage data in response to the input;
calculating hash values for the first and second data blocks in the selected section of data blocks;
calculating a parent hash value for the common parent node based on a concatenation of hash values of the first and second data blocks; and
replacing the selected section with the parent hash value.

**14.** The device of claim 13, the operations further comprising communicating to the third party the energy usage data including the parent hash value as a replacement for the selected section.

**15.** The device of claim 13, wherein the parent hash value for the common parent node is calculated according to an equation:

$$H_P = H(D_S, H(L,R))$$

in which:

$D_S$ represents a sum of all data values pertaining to the common parent node, the data values pertaining to the common parent node including data values of the first and second data blocks;
$H(L,R)$ includes a hash value based on a concatenation of hash values of child nodes of the common parent node, the child nodes including the hash values of the first and second data blocks; and
$H(D_S H(L,R))$ includes a hash of $D_S$ and $H(L,R)$.

**16.** The device of claim 9, wherein:

the receiving input comprises receiving input effective to select a first granularity level and a different second granularity level to apply to the energy usage data; and

the down-sampling comprises down-sampling the energy usage data to produce down-sampled energy usage data at the first granularity level and the different second granularity level.

**17.** A method of generating digitally-signed time-series data that includes energy usage data, the method comprising:

receiving time-series data;
sorting the time-series data sequentially according to timestamps of individual data values of the time-series data;
generating a data structure that includes a plurality of leaf nodes, a plurality of common parent nodes; and a root node; and
generating a digital signature of the energy usage data from the root node and a private key of a data issuer;
wherein after down-sampling of the time-series data including aggregating two or more of the individual data values into one or more aggregated data values, an integrity and authenticity of the down-sampled time-series data is verifiable with one or more of the digital signature, the aggregated data values, the down-sampled time-series data, hash values of child nodes corresponding to the down-sampled time-series data, or a public key of the data issuer that corresponds to the private key.

**18.** The method of claim 17, wherein the integrity and authenticity of the down-sampled time-series data is verifiable without the two or more of the individual data values aggregated into the one or more aggregated data values.

**19.** The method of claim 17, wherein the generating the data structure comprises:

calculating the plurality of leaf nodes by calculating hash values of the individual data values;
calculating the plurality of common parent nodes by, for each common parent node, calculating a hash value of a sum of all individual data values pertaining to the common parent node and of a hash value of a concatenation of hash values of two or more child nodes of the common parent node; and
calculating the root node by calculating a hash value of a sum of all of the individual data values in the time-series data and of a hash value of a concatenation of hash values of two or more child nodes of the root node, wherein the hash values of the two or more child nodes of the root node include hash values of two or more of the plurality of common parent nodes that are at a level of the data structure immediately beneath the root node.

20. The method of claim 17, wherein the data issuer comprises a utility that distributes energy and the receiving comprises receiving energy usage data from a meter at a site to which energy is distributed by the utility, the energy usage data including meter readings generated by the meter.

**Fig. 1A**

*Fig. 1B*

EP 3 082 078 A1

**Fig. 2**

*1-Hour Granularity*

*30-Min Granularity*

*15-Min Granularity*

_300_

Prepare Time-Series Data To Be Signed _302_

Calculate Hash Value Of Each
Value In The Time-Series Data _304_

Calculate Common Parent Node Hash Values _306_

Digitally Sign Root Node _308_

**_Fig. 3_**

400

┌─────────────────────────────────────────────┐
│                                               │
│         Receive Energy Usage Data             │  402
│                                               │
└─────────────────────────────────────────────┘
                      │
                      ▼
┌─────────────────────────────────────────────┐
│      Receive Input From Customer Effective    │  404
│         To Select Granularity Level           │
│                                               │
└─────────────────────────────────────────────┘
                      │
                      ▼
┌─────────────────────────────────────────────┐
│                                               │
│        Down-Sample Energy Usage Data          │  406
│                                               │
└─────────────────────────────────────────────┘
                      │
                      ▼
┌─────────────────────────────────────────────┐
│   Communicate Down-Sampled Energy Usage Data  │
│   And Hash Values Of Child Nodes Corresponding To │  408
│   Down-Sampled Energy Usage Data To Third Party │
└─────────────────────────────────────────────┘

## Fig. 4A

450

```
                                                    452
┌─────────────────────────────────────────┐
│                                          │
│          Receive Energy Usage Data       │
│                                          │
└─────────────────────────────────────────┘

                                                    454
┌─────────────────────────────────────────┐
│     Receive Input From Customer Effective To     │
│     Select First and Second Granularity Levels   │
└─────────────────────────────────────────┘

                                                    456
┌─────────────────────────────────────────┐
│        Down-Sample Energy Usage Data To          │
│        First and Second Granularity Levels       │
└─────────────────────────────────────────┘

                                                    458
┌─────────────────────────────────────────┐
│    Communicate Down-Sampled Energy Usage Data    │
│    And Hash Values Of  Child Nodes Corresponding To  │
│    Down-Sampled Energy Usage Data To Third Party │
└─────────────────────────────────────────┘
```

*Fig. 4B*

*Fig. 5*

Fig. 6

**Computing Device** _600_

**Basic Configuration** _602_

**System Memory** _606_

**ROM/RAM**

Operating System _620_

Application _622_

Down-Sampling Algorithm _626_

Program Data _624_

Energy Usage Data _628_

**Processor** _604_

μP/μC/DSP

Level 1 Cache _610_

Level 2 Cache _612_

Processor Core ALU/FPU/DSP _614_

Registers _616_

Memory Controller _618_

**Memory Bus** _608_

**Storage Device(s)** _632_

Removable Storage (e.g., CD/DVD) _636_

Non-Removable Storage (e.g., HDD) _638_

Bus/Interface Controller _630_

**Storage Interface Bus** _634_

Interface Bus _640_

**Output Devices** _642_

Graphics Processing Unit _648_

Audio Processing Unit _650_

A/V Port(s) _652_

**Peripheral Interfaces** _644_

Serial Interface Controller _654_

Parallel Interface Controller _656_

I/O Port(s) _658_

**Communication Devices** _646_

Network Controller _660_

Comm. Port(s) _664_

Other Computing Device(s) _662_

EP 3 082 078 A1

Europäisches
Patentamt

European
Patent Office

Office européen
des brevets

# EUROPEAN SEARCH REPORT

Application Number

EP 15 18 5859

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/053869 A1 (OWEN JAMES E [US]) 1 March 2012 (2012-03-01) * abstract * * figures 4,6 * * paragraph [0002] * * paragraph [0003] - paragraph [0004] * * paragraph [0016] - paragraph [0018] * ----- | 1-20 | INV. G06Q10/04 G06Q50/06 G01R22/06 |
| X,D | US 2015/025934 A1 (MASHIMA DAISUKE [US] ET AL) 22 January 2015 (2015-01-22) * abstract * * figures 1, 2 * * paragraph [0015] - paragraph [0017] * * paragraph [0051] - paragraph [0067] * ----- | 1-20 | |
| A | WO 01/11843 A1 (SUDIA FRANK W [US]) 15 February 2001 (2001-02-15) * the whole document * ----- | 1-20 | |

TECHNICAL FIELDS
SEARCHED       (IPC)

G06Q
G01R

The present search report has been drawn up for all claims

| Place of search | Date of completion of the search | Examiner |
|---|---|---|
| The Hague | 2 August 2016 | van der Weiden, Ad |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 ...........................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 18 5859

This annex lists the patent family members relating to the patent documents cited in  the above-mentioned European search report.
The members are as contained in the European Patent Office EDP file on
The European Patent Office is in no way liable for these particulars which are merely given for the purpose of information.

02-08-2016

| Patent document cited in search report | | Publication date | Patent family member(s) | | Publication date |
|---|---|---|---|---|---|
| US 2012053869 | A1 | 01-03-2012 | US<br>WO | 2012053869 A1<br>2012029961 A1 | 01-03-2012<br>08-03-2012 |
| US 2015025934 | A1 | 22-01-2015 | JP<br>US | 2015022753 A<br>2015025934 A1 | 02-02-2015<br>22-01-2015 |
| WO 0111843 | A1 | 15-02-2001 | AU<br>US<br>WO | 6620000 A<br>2005114666 A1<br>0111843 A1 | 05-03-2001<br>26-05-2005<br>15-02-2001 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 49894214 A
- US 94299513 A
- US 498942 A